# EUROPEAN PATENT APPLICATION

(11) **EP 4 723 165 A1**
(43) Date of publication of application: **08.04.2026**
(21) Application number: 24830707.6
(22) Date of filing: 24.06.2024
(51) Int. Cl.: H01L 21/768

(54) **SEMICONDUCTOR STRUCTURE AND PREPARATION METHOD THEREFOR, AND FUNCTIONAL CHIP AND ELECTRONIC DEVICE**

(30) Priority: 27.06.2023 CN 202310770844
(71) Applicant: Huawei Technologies Co., Ltd., Shenzhen, Guangdong 518129 (CN)
(72) Inventor: WANG, Cheng, Shenzhen, Guangdong 518129 (CN); ZHU, Jifeng, Shenzhen, Guangdong 518129 (CN); WANG, Yechang, Shenzhen, Guangdong 518129 (CN); DONG, Jinwen, Shenzhen, Guangdong 518129 (CN)
(74) Representative: Pfenning, Meinig & Partner mbB
(86) International application number: PCT/CN2024/101062
(87) International publication number: WO 2025/002065

(57) **Abstract**

Embodiments of this application provide a semiconductor structure and a preparation method therefor, a functional chip, and an electronic device, and relate to the field of semiconductor structure technologies. The method for preparing the semiconductor structure includes providing a semiconductor layer group, where the semiconductor layer group includes a first dielectric layer, a semiconductor layer, a conductive structure, and an electronic element. A part of the semiconductor layer is removed from a side of a second surface of the semiconductor layer along a first direction, to expose an end face of the conductive structure away from the electronic element. A protection structure is formed on a side of the conductive structure away from the first dielectric layer, where an orthographic projection of the protection structure on the semiconductor layer covers an orthographic projection of the exposed end face of the conductive structure on the semiconductor layer. The part of the semiconductor layer is etched from the side of the second surface of the semiconductor layer along the first direction by using the protection structure as a mask. **In** embodiments of this application, the protection structure is disposed, so that residual conductive metal particles can be reduced, and electrical reliability of the semiconductor layer can be improved.

## Description

This application claims priority to Chinese Patent Application No. 202310770844.3, filed with the China National Intellectual Property Administration on June 27, 2023 and entitled "SEMICONDUCTOR STRUCTURE AND PREPARATION METHOD THEREFOR, FUNCTIONAL CHIP, AND ELECTRONIC DEVICE", which is incorporated herein by reference in its entirety.

### TECHNICAL FIELD

Embodiments of this application relate to the field of semiconductor structure technologies, and in particular, to a semiconductor structure and a preparation method therefor, a functional chip, and an electronic device.

### BACKGROUND

A chip usually includes a semiconductor structure, and the semiconductor structure may include a semiconductor layer and a conductive structure made of a metal material. In a related technology, when the semiconductor structure is prepared, the conductive structure easily causes metal contamination to the semiconductor layer. This affects electrical reliability of the semiconductor structure.

### SUMMARY

Embodiments of this application provide a semiconductor structure and a preparation method therefor, a functional chip, and an electronic device, to improve electrical performance of the semiconductor structure.

To achieve the foregoing objective, this application provides the following technical solutions.

According to an aspect, an embodiment of this application provides a method for preparing a semiconductor structure. The method for preparing the semiconductor structure includes providing a semiconductor layer group, where the semiconductor layer group includes a first dielectric layer, a semiconductor layer, a conductive structure, and an electronic element; the semiconductor layer includes a first surface and a second surface that are disposed opposite to each other, the first dielectric layer is disposed adjacent to the first surface of the semiconductor layer, and the electronic element is located in the first dielectric layer; and one end of the conductive structure is located in the first dielectric layer and electrically connected to the electronic element, and the other end of the conductive structure passes through the first surface of the semiconductor layer and extends into the semiconductor layer; removing a part of the semiconductor layer from a side of the second surface of the semiconductor layer along a first direction, to expose an end face of the conductive structure away from the electronic element, where the first direction intersects the surface of the semiconductor layer; forming a protection structure on a side of the conductive structure away from the first dielectric layer, where an orthographic projection of the protection structure on the semiconductor layer covers an orthographic projection of the exposed end face of the conductive structure on the semiconductor layer; etching a part of the semiconductor layer from the side of the second surface of the semiconductor layer along the first direction by using the protection structure as a mask; and removing the protection structure.

In this embodiment of this application, the protection structure is formed on the side of the conductive structure away from the first dielectric layer. The orthographic projection of the protection structure on the semiconductor layer covers the orthographic projection of the exposed end face (namely, the end face of the conductive structure away from the electronic element) of the conductive structure on the semiconductor layer, so that the protection structure is capable of covering the end face of the conductive structure away from the electronic element.

In this way, the protection structure can be used as the mask. When the part of the semiconductor layer is etched from the side of the second surface of the semiconductor layer along the first direction, an etching ion beam does not bombard the end face of the conductive structure away from the electronic element. This reduces a risk that metal particles fall on the second surface of the semiconductor layer because the conductive structure splashes under action of the etching ion beam when the part of the semiconductor layer is etched. Therefore, residual conductive metal particles can be reduced, metal pollution caused by the conductive structure to the semiconductor layer can be reduced, and electrical reliability of the semiconductor structure can be improved.

In addition, after the part of the semiconductor layer is etched, the protection structure is removed, so that the protection structure does not affect a subsequent processing process.

In some possible implementations, the semiconductor layer group further includes a second dielectric layer, and the second dielectric layer wraps the conductive structure; and when etching the part of the semiconductor layer from the side of the second surface of the semiconductor layer along the first direction by using the protection structure as the mask, the method further includes: etching a first part of the second dielectric layer, where the first part of the second dielectric layer wraps an outer peripheral side of an end part of the conductive structure away from the electronic element, and is away from the conductive structure in a second direction, and the second direction is parallel to the surface of the semiconductor layer. In this way, a risk that the semiconductor layer remains on a surface of the second dielectric layer away from the conductive structure because the semiconductor layer is adhered to the second dielectric layer can be reduced, and reliability of a method for preparing a semiconductor structure can be improved. In addition, a remaining part of the second dielectric layer (a second part of the second dielectric layer) can protect the outer peripheral side of the end part of the conductive structure away from the electronic element. In other words, the protection structure can protect the end face of the conductive structure away from the electronic element, and the remaining part of the second dielectric layer can protect the outer peripheral side of the end part of the conductive structure away from the electronic element, to prevent an etching ion beam from bombarding the end part (including the end face and the outer peripheral side) of the conductive structure away from the electronic element when the semiconductor layer is etched. This reduces metal pollution caused by the conductive structure to the semiconductor layer and improves electrical reliability of the semiconductor structure.

In some possible implementations, an edge of the orthographic projection of the protection structure on the semiconductor layer is located between an orthographic projection of a surface of the second dielectric layer away from the conductive structure on the semiconductor layer and an orthographic projection of a surface of the second dielectric layer close to the conductive structure on the semiconductor layer. In this way, the protection structure can protect the end face of the conductive structure away from the electronic element and the second part of the second dielectric layer, and the first part of the second dielectric layer can be removed through etching. This reduces a risk that the semiconductor layer remains on the surface of the second dielectric layer away from the conductive structure because the semiconductor layer is adhered to the second dielectric layer, and improves reliability of a method for preparing a semiconductor structure.

In some possible implementations, forming the protection structure on the side of the conductive structure away from the first dielectric layer includes: forming a photoresist layer on a side of the semiconductor layer away from the first dielectric layer; and patterning the photoresist layer in an exposure development manner, to form the protection structure. In this way, a complex preparation method is not required, the preparation process of the semiconductor structure is simplified and preparation costs of the semiconductor structure are reduced while improving electrical performance of the semiconductor structure.

In some implementations, before forming the photoresist layer on the side of the semiconductor layer away from the first dielectric layer, the method includes: forming an isolation layer on the side of the second surface of the semiconductor layer, where the isolation layer covers the semiconductor layer and the exposed end face of the conductive structure; and before etching the part of the semiconductor layer from the side of the second surface of the semiconductor layer along the first direction by using the protection structure as the mask, the method further includes: etching, by using the protection structure as the mask, the part of the semiconductor layer that is covered by the isolation layer. In this way, the isolation layer can isolate the photoresist layer from the end face of the conductive structure away from the electronic element, to avoid contact between the photoresist layer and the end face of the conductive structure away from the electronic element, so as to avoid pollution of the end face of the conductive structure away from the electronic element by the photoresist layer, and improve electrical reliability of the semiconductor structure. In addition, before etching the part of the semiconductor layer, a part of the semiconductor layer that is covered by the isolation layer is etched, to enable the semiconductor layer to be exposed. This avoids impact of the isolation layer on a subsequent process.

In some possible implementations, after removing the protection structure, the method further includes: forming a third dielectric layer, where the third dielectric layer covers the second surface of the semiconductor layer and wraps an end part of the conductive structure protruding from the semiconductor layer; and removing a part of the third dielectric layer and the isolation layer along the first direction, to expose the end face of the conductive structure away from the electronic element. In this way, the end face of the conductive structure away from the electronic element can be exposed, so that another component (for example, an external component or another semiconductor structure) can be electrically connected to the semiconductor structure by using the conductive structure. In addition, the third dielectric layer can implement an electrical isolation function, to improve reliability of the semiconductor structure when the semiconductor structure is electrically connected to another component.

In some possible implementations, there are a plurality of conductive structures, and the plurality of conductive structures include a first conductive structure and a second conductive structure; and before removing the part of the semiconductor layer from the side of the second surface of the semiconductor layer along the first direction, to expose the end face of the conductive structure away from the electronic element, a distance between an end face of the first conductive structure away from the electronic element and the second surface of the semiconductor layer is not equal to a distance between an end face of the second conductive structure away from the electronic element and the second surface of the semiconductor layer; and removing the part of the semiconductor layer from the side of the second surface of the semiconductor layer along the first direction, to expose the end face of the conductive structure away from the electronic element includes: removing the part of the semiconductor layer and a part of the conductive structure from the side of the second surface of the semiconductor layer along the first direction, to expose the end faces of the first conductive structure and the second conductive structure away from the electronic element, where the exposed end face of the first conductive structure is flush with the exposed end face of the second conductive structure. In this way, another external component can be electrically connected to the first conductive structure and the second conductive structure, and different semiconductor structures can be electrically connected to each other by using the first conductive structure and the second conductive structure, to meet different requirements. In addition, the exposed end face of the first conductive structure is flush with the exposed end face of the second conductive structure, to improve structural regularity of the semiconductor structure and improve processing convenience of the semiconductor structure in a subsequent process.

According to another aspect, an embodiment of this application provides a semiconductor structure. The semiconductor structure includes a semiconductor layer group and a third dielectric layer. The semiconductor layer group includes a first dielectric layer, a semiconductor layer, a second dielectric layer, a conductive structure, and an electronic element; the semiconductor layer includes a first surface and a second surface that are disposed opposite to each other, the first dielectric layer is disposed adjacent to the first surface of the semiconductor layer, and the electronic element is located in the first dielectric layer; one end of the conductive structure is located in the first dielectric layer and is electrically connected to the electronic element; and the second dielectric layer wraps the conductive structure. The third dielectric layer is disposed adjacent to the second surface of the semiconductor layer; and one end of the conductive structure away from the electronic element passes through the semiconductor layer and the third dielectric layer, and an end face of the conductive structure away from the electronic element is exposed in the third dielectric layer, where the second dielectric layer includes a first subpart and a second subpart, the first subpart is located between the third dielectric layer and the conductive structure, and the second subpart is located between the semiconductor layer and the conductive structure; and a thickness of the first subpart is less than a thickness of the second subpart. In this way, a risk that a surface of the first subpart away from the conductive structure is adhered to the semiconductor layer can be reduced, and electrical reliability of the semiconductor structure is improved.

According to still another aspect, an embodiment of this application provides a functional chip. The functional chip includes at least one semiconductor structure. The semiconductor structure is the foregoing semiconductor structure, or the semiconductor structure is manufactured according to the foregoing method for preparing the semiconductor structure.

The functional chip provided in this embodiment of this application includes the foregoing semiconductor structure. Alternatively, the semiconductor structure in the functional chip provided in this embodiment of this application is manufactured according to the foregoing method for preparing the semiconductor structure. Therefore, the functional chip provided in this embodiment of this application has all the foregoing beneficial effects. Details are not described herein again.

In some possible implementations, when the functional chip includes at least two semiconductor structures, the at least two semiconductor structures include a first semiconductor structure and a second semiconductor structure; and an exposed end face of a conductive structure in the first semiconductor structure is bonded to an exposed end face of a conductive structure in the second semiconductor structure. In this way, when the first semiconductor structure and the second semiconductor structure are disposed in a stacked manner, an electronic element in the first semiconductor structure can be electrically connected to an electronic element in the second semiconductor structure, so that inter-layer interconnection of a bonded wafer is implemented and the functional chip can become a 3D IC.

According to still another aspect, an embodiment of this application provides an electronic device. The electronic device includes a bus and the foregoing functional chip, and the functional chip is electrically connected to the bus.

The electronic device provided in this embodiment of this application includes the foregoing functional chip, and therefore has all the foregoing beneficial effects. Details are not described herein again.

### BRIEF DESCRIPTION OF DRAWINGS

FIG. 1 is a block diagram of a structure of an electronic device according to some embodiments of this application;
FIG. 2 is a flowchart of steps of a method for preparing a semiconductor structure according to some embodiments of this application;
FIG. 3 is a diagram of a structure of a semiconductor layer group according to some embodiments of this application;
FIG. 4 is a diagram of a structure of a semiconductor layer group according to some other embodiments of this application;
FIG. 5 is a diagram of an electron microscope of a semiconductor structure according to some embodiments of this application;
FIG. 6 is a diagram of a structure of a semiconductor layer group according to still some other embodiments of this application;
FIG. 7 is a diagram of a structure of a semiconductor layer group according to still some other embodiments of this application;
FIG. 8 is a diagram of a structure of a semiconductor layer group according to still some other embodiments of this application;
FIG. 9 is a diagram of an electron microscope of a conductive structure according to some embodiments of this application;
FIG. 10 is a diagram of a structure of a semiconductor layer group according to still some other embodiments of this application;
FIG. 11 is a diagram of a structure of a semiconductor layer group according to still some other embodiments of this application;
FIG. 12 is a diagram of a structure of a functional chip according to some embodiments of this application;
FIG. 13 is a locally enlarged diagram of a region M1 in FIG. 9;
FIG. 14 is a diagram of a curve in which an effective copper diffusion coefficient changes with a temperature;
FIG. 15 is a diagram of diffusion depth curves of different metals in a same medium;
FIG. 16 is a flowchart of steps of a method for preparing a semiconductor structure according to some other embodiments of this application;
FIG. 17 is a diagram of a structure of a semiconductor layer group according to still some other embodiments of this application;
FIG. 18 is a diagram of a structure of a semiconductor layer group according to still some other embodiments of this application;
FIG. 19 is a diagram of a structure of a semiconductor layer group according to still some other embodiments of this application;
FIG. 20 is a locally enlarged diagram of a region M2 in FIG. 19;
FIG. 21 is a diagram of a position relationship between an edge of an orthographic projection of a protection structure on a semiconductor layer and an orthographic projection of a second dielectric layer on the semiconductor layer according to some embodiments of this application;
FIG. 22 is a flowchart of steps of a method for preparing a semiconductor structure according to still some other embodiments of this application;
FIG. 23 is a diagram of a structure of a semiconductor layer group according to still some other embodiments of this application;
FIG. 24 is a diagram of a structure of a semiconductor layer group according to still some other embodiments of this application;
FIG. 25 is a diagram of a structure of a semiconductor layer group according to still some other embodiments of this application; and
FIG. 26 is a diagram of a structure of a semiconductor structure according to some embodiments of this application.

### DESCRIPTION OF EMBODIMENTS

The following clearly and completely describes technical solutions in some embodiments of this application with reference to the accompanying drawings. It is clear that the described embodiments are merely some rather than all embodiments of this application. All other embodiments obtained by a person of ordinary skill in the art based on embodiments of this application shall fall within the protection scope of this application.

Unless otherwise required in the context, throughout this specification and claims, the term "include (comprise)" and other forms of the term, for example, a third person singular form "includes (comprises)" and a present participle form "including (comprising)", are interpreted as "open and inclusive", namely, "include but not limited to". In descriptions of the specification, the terms such as "one embodiment (one embodiment)", "some embodiments (some embodiments)", "an example embodiment (example embodiment)", "an example (example)", "a specific example (specific example)", or "some examples (some examples)" are intended to indicate that a specific feature, structure, material, or characteristic related to the embodiment or example is included in at least one embodiment or example of this application. The schematic representations of the foregoing terms do not necessarily refer to a same embodiment or example. Further, the particular feature, structure, material, or characteristic may be included in any one or more embodiments or examples in any appropriate manner.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In the descriptions of embodiments of this application, unless otherwise specified, "a plurality of" means two or more.

"At least one of A, B, and C" and "at least one of A, B, or C" have the same meaning, and both include the following combinations of A, B, and C: only A, only B, only C, a combination of A and B, a combination of A and C, a combination of B and C, and a combination of A, B, and C.

"A and/or B" includes the following three combinations: only A, only B, and a combination of A and B.

As used herein, "parallel", "perpendicular to", and "equal to" include described cases and similar cases. A range of a similar case is in an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°. "Equal to" includes "absolutely equal to" and "approximately equal to". An acceptable deviation range of "approximately equal to" may be that, for example, a difference between two equal objects is less than or equal to 5% of either of the two objects.

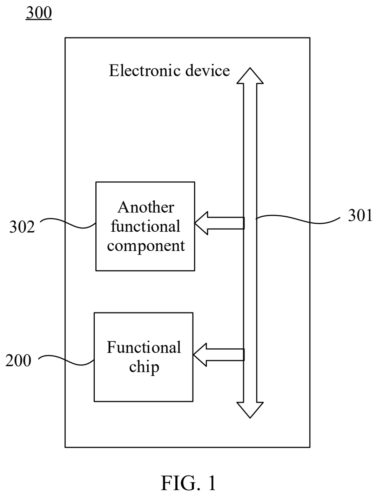

FIG. 1 is a block diagram of a structure of an electronic device according to some embodiments of this application.

As shown in FIG. 1, embodiments of this application provide an electronic device 300. For example, the electronic device 300 may be a terminal device, for example, a mobile phone, a tablet computer, or a smart band. Alternatively, the electronic device 300 may be a personal computer (English full name: Personal Computer, English abbreviation: PC), a server, a workstation, or the like.

In some examples, as shown in FIG. 1, the electronic device 300 may include a bus 301 and a functional chip 200. The functional chip 200 may be electrically connected to the bus 301.

It may be understood that the bus 301 is a common communication trunk for transmitting information between different functional components of the electronic device 300. The functional chip 200 is electrically connected to the bus 301, so that a signal can be transmitted between the functional chip 200 and the bus 301. In some examples, as shown in FIG. 1, the electronic device 300 may further include another functional component 302. The another functional component 302 is electrically connected to the bus 301. In this way, a signal can be transmitted between the functional chip 200 and the another functional component 302 through the bus 301, so that the electronic device 300 can implement different functions.

In some examples, the functional chip 200 can implement at least one of a storage function and a computing function. In some other examples, the functional chip 200 can also implement a function other than the storage function and the computing function. It may be understood that a function that can be implemented by the functional chip 200 is not further limited in embodiments of this application.

In some examples, the functional chip 200 may be a 3D IC (English full name: Three-Dimensional Integrated Circuit, Chinese name: three-dimensional integrated circuit). For example, the functional chip 200 may be at least one of an application processor (English full name: Application Processor, English abbreviation: AP), a graphics processing unit (English full name: Graphics Processing Unit, English abbreviation: GPU), a central processing unit (English full name: Central Processing Unit, English abbreviation: CPU), a random access memory (English full name: Random Access Memory, English abbreviation: RAM), a read-only memory (English full name: Read-Only Memory, English abbreviation: ROM), a communication chip, or a power management chip. The electronic device 300 may include one functional chip 200, or may include a plurality of functional chips 200.

In some examples, the functional chip 200 may include at least one semiconductor structure 100. For example, the functional chip 200 may include only one semiconductor structure 100, or the functional chip 200 may include two, three, four, or more semiconductor structures 100.

When the functional chip 200 includes a plurality of semiconductor structures 100, at least two of the plurality of semiconductor structures 100 may be electrically connected. For example, the at least two semiconductor structures 100 may be electrically connected in a bonding manner. Compared with implementing electrical connection between the at least two semiconductor structures 100 by using a conducting wire, implementing electrical connection between the at least two semiconductor structures 100 in the bonding manner reduces routing complexity of the functional chip 200, and can shorten a distance between the at least two semiconductor structures 100 that are electrically connected.

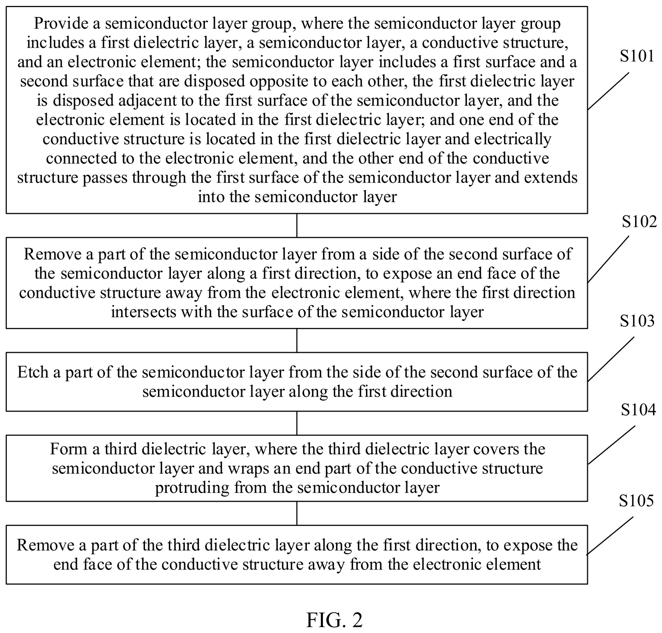

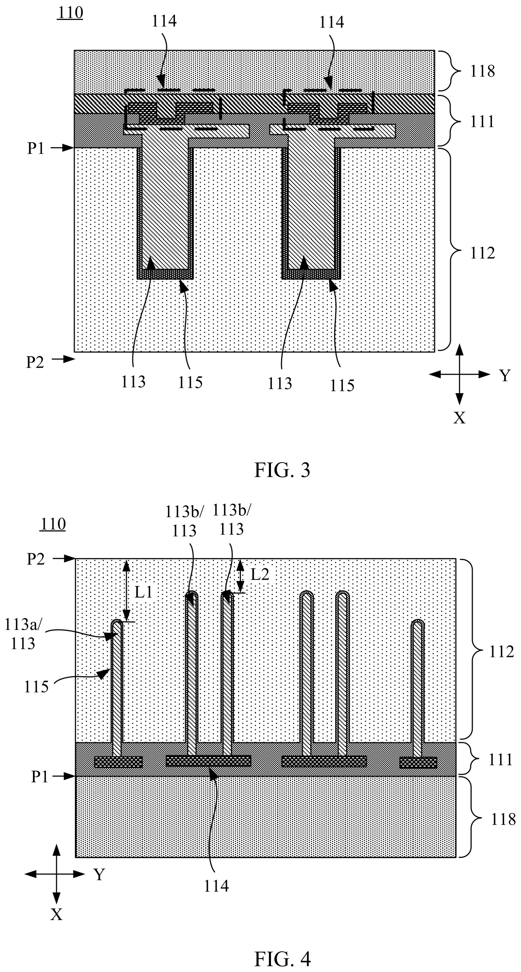

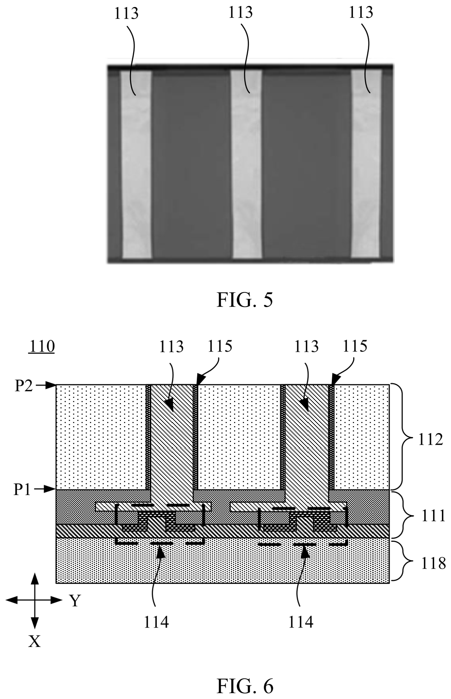

FIG. 2 is a flowchart of steps of a method for preparing a semiconductor structure according to some embodiments of this application. FIG. 3 is a diagram of a structure of a semiconductor layer group according to some embodiments of this application. FIG. 4 is a diagram of a structure of a semiconductor layer group according to some other embodiments of this application. FIG. 5 is a diagram of an electron microscope of a semiconductor structure according to some embodiments of this application.

The following describes the method for preparing the semiconductor structure 100 by using an example. In some examples, as shown in FIG. 2, the method for preparing the semiconductor structure 100 includes the following steps.

Step S101: Provide a semiconductor layer group, where the semiconductor layer group includes a first dielectric layer, a semiconductor layer, a conductive structure, and an electronic element; the semiconductor layer includes a first surface and a second surface that are disposed opposite to each other, the first dielectric layer is disposed adjacent to the first surface of the semiconductor layer, and the electronic element is located in the first dielectric layer; and one end of the conductive structure is located in the first dielectric layer and electrically connected to the electronic element, and the other end of the conductive structure passes through the first surface of the semiconductor layer and extends into the semiconductor layer;

For example, as shown in FIG. 3, a semiconductor layer group 110 may include a first dielectric layer 111, a semiconductor layer 112, a conductive structure 113, and an electronic element 114. A material of the first dielectric layer 111 may be an oxide (English name: oxide), for example, silicon dioxide (chemical formula: SiO₂); or a material of the first dielectric layer 111 may be a nitride (English name: nitride), for example, silicon nitride (chemical formula: SiN); or a material of the first dielectric layer 111 may be one or a combination of a plurality of other insulation materials with a high dielectric constant.

For example, the first dielectric layer 111 may include a plurality of stacked sublayers (refer to FIG. 3), and the electronic element 114 may be located in the plurality of stacked sublayers. Materials of different sublayers may be the same or different.

In some examples, a material of the semiconductor layer 112 may include silicon (chemical formula: Si). For example, the semiconductor layer 112 may be pure silicon or doped silicon.

As shown in FIG. 3 and FIG. 4, the semiconductor layer 112 may include a first surface P1 and a second surface P2 that are disposed opposite to each other, and the first surface P1 and the second surface P2 may be smooth planes. The first dielectric layer 111 is located on a side on which the first surface P1 of the semiconductor layer 112 is located, and is disposed adjacent to the first surface P1. For example, the first dielectric layer 111 may be in contact with the first surface P1 of the semiconductor layer 112.

It may be understood that the electronic element 114 may be an element having functions such as storage, calculation, switching, digital-to-analog conversion, and analog-to-digital conversion. There may be a plurality of electronic elements 114, and functions of the plurality of electronic elements 114 may be the same or may be different.

As shown in FIG. 3 and FIG. 4, one end of the conductive structure 113 is located in the first dielectric layer 111 and is electrically connected to the electronic element 114, so that a signal can be transmitted between the electronic element 114 and the conductive structure 113. It may be understood that the conductive structure 113 and the electronic element 114 may be directly electrically connected, or the conductive structure 113 and the electronic element 114 may be electrically connected by using another conductive trace structure (for example, a conductive trace and a metal interconnection structure, which are not shown in FIG. 3 and FIG. 4).

In some examples, the conductive structure 113 and the electronic element 114 may be electrically connected in a one-to-one correspondence. In some other examples, one conductive structure 113 may be electrically connected to a plurality of electronic elements 114. Alternatively, a plurality of conductive structures 113 may be electrically connected to one electronic element 114.

As shown in FIG. 3 and FIG. 4, an extension direction of the conductive structure 113 may intersect with a surface (including the first surface P1 and the second surface P2) of the semiconductor layer 112, so that the other end of the conductive structure 113 can pass through the first surface P1 of the semiconductor layer 112 and extend into the semiconductor layer 112. For example, the extension direction of the conductive structure 113 may be perpendicular to the surface of the semiconductor layer 112.

In some examples, a TSV (English full name: Through Silicon Via, Chinese name: through silicon via) technology may be used to form the conductive structure 113. For example, a conductive via may be formed on the semiconductor layer 112 through the first surface P1 of the semiconductor layer 112, and the conductive structure 113 is formed in the conductive via. A material of the conductive structure 113 may be a metal material like copper, aluminum, iron, or silver, to improve conductivity of the conductive structure 113. It may be understood that the material of the conductive structure 113 is not further limited in embodiments of this application.

FIG. 5 is a diagram of an electron microscope cross section of the conductive structure 113 in a direction perpendicular to the surface (for example, the first surface P1 or the second surface P2) of the semiconductor layer 112. It may be understood that, to clearly show the conductive structure 113, another structure of the semiconductor layer group 110 is not shown in FIG. 5.

In some examples, a shape of the conductive structure 113 may be a shape, for example, a cylinder, a cuboid, or a prism, so that a cross-sectional shape of the conductive structure 113 in a direction perpendicular to a surface of the semiconductor layer 112 may be a rectangle. In some other examples, the conductive structure 113 may alternatively be in another irregular shape.

For example, the shape of the conductive structure 113 is a cylinder. In some examples, a diameter of a bottom surface of the cylinder may be 5 µm (unit: micrometer), and a height of the cylinder may be 50 µm. In some other examples, the conductive structure 113 may alternatively be in another size. It may be understood that a shape and a size of the conductive structure 113 are not further limited in embodiments of this application.

In some examples, as shown in FIG. 3 and FIG. 4, the semiconductor layer group 110 may further include a second dielectric layer 115, and the second dielectric layer 115 wraps the conductive structure 113.

For example, the second dielectric layer 115 may be located in the semiconductor layer 112, and wraps the conductive structure 113. It may be understood that the second dielectric layer 115 can be used for electrical isolation. For example, a material of the second dielectric layer 115 may be an oxide (English name: oxide), for example, silicon dioxide (chemical formula: SiO₂); or a material of the second dielectric layer 115 may be a nitride (English name: nitride), for example, silicon nitride (chemical formula: SiN); or a material of the second dielectric layer 115 may be one or a combination of a plurality of other insulation materials with a high dielectric constant. The material of the second dielectric layer 115 and a material of the first dielectric layer 111 may be the same or different.

For example, after the conductive via is formed on the semiconductor layer 112, the second dielectric layer 115 may be formed on an inner wall of the conductive via, and then the conductive structure 113 is formed on a side of the second dielectric layer 115 away from the semiconductor layer 112, so that the second dielectric layer 115 can wrap the conductive structure 113.

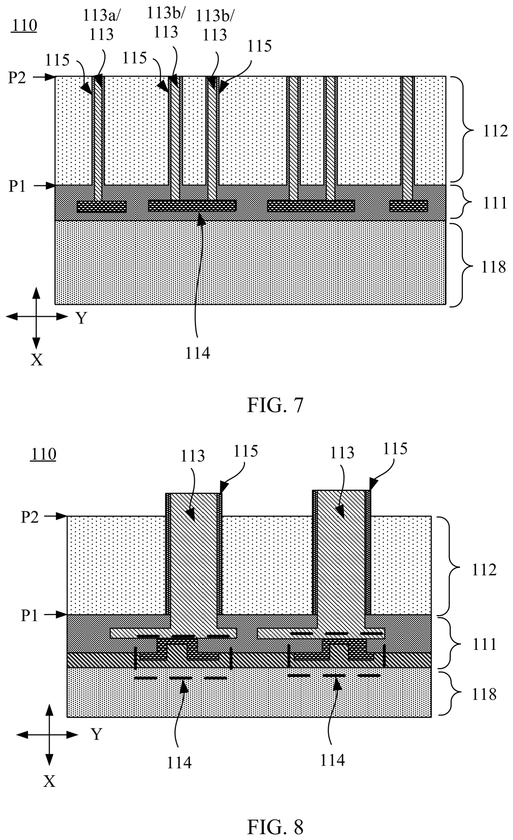

FIG. 6 is a diagram of a structure of a semiconductor layer group according to still some other embodiments of this application. FIG. 7 is a diagram of a structure of a semiconductor layer group according to still some other embodiments of this application.

Refer to FIG. 2 again. After the semiconductor layer group 110 is provided (that is, after step S101), the method for preparing the semiconductor structure 100 further includes the following steps.

Step S102: Remove a part of the semiconductor layer from a side of the second surface of the semiconductor layer along a first direction, to expose an end face of the conductive structure away from the electronic element, where the first direction intersects the surface of the semiconductor layer.

In some examples, the first direction X may be perpendicular to the surface (including the first surface P1 and the second surface P2) of the semiconductor layer 112.

It may be understood that because one end of the conductive structure 113 away from the electronic element 114 passes through the first surface P1 of the semiconductor layer 112 and extends into the semiconductor layer 112, the part of the semiconductor layer 112 is removed from the side of the second surface P2 of the semiconductor layer 112 along the first direction X, as shown in FIG. 6 and FIG. 7, to expose the end face of the conductive structure 113 away from the electronic element 114. For example, the exposed end face of the conductive structure 113 is flush with the second surface P2 of the semiconductor layer 112.

For example, a process of removing the part of the semiconductor layer 112 from the side of the second surface P2 of the semiconductor layer 112 along the first direction X to expose the end face of the conductive structure 113 away from the electronic element 114 may be referred to as a backside via reveal (English full name: Backside Via Reveal, English abbreviation: BVR) process.

It may be understood that the BVR process may be used to expose the end face of the conductive structure 113 away from the electronic element 114, so that another external component can be electrically connected to the electronic element 114 through the conductive structure 113, or two different semiconductor structures 100 can be electrically connected through the conductive structure 113. This improves electrical reliability of the semiconductor structure 100 in a subsequent processing process.

In some examples, a CMP (English full name: Chemical Mechanical Polishing, Chinese name: chemical mechanical polishing) process may be used to thin the semiconductor layer 112 from an initial thickness (for example, 75 µm) to a specified thickness, to expose the end face of the conductive structure 113 away from the electronic element 114. It may be understood that the CMP process is used to remove the part of the semiconductor layer 112, so that the end face of the conductive structure 113 away from the electronic element 114 can be exposed, and polishing and flattening processing can be performed on the second surface P2 of the semiconductor layer 112 and the end face of the conductive structure 113 away from the electronic element 114. This improves structural regularity of the semiconductor structure 100.

It may be understood that when the part of the semiconductor layer 112 is not removed, the second surface P2 is a surface disposed opposite to the first surface P1. After the part of the semiconductor layer 112 is removed from the side of the second surface P2 of the semiconductor layer 112 along the first direction X, the second surface P2 is a surface disposed opposite to the first surface P1 in a remaining part of the semiconductor layer 112.

For example, when the part of the semiconductor layer 112 is removed from the side of the second surface P2 of the semiconductor layer 112, the second dielectric layer 115 covering the end face of the conductive structure 113 away from the electronic element 114 may be removed, as shown in FIG. 6 and FIG. 7, so that the end face of the conductive structure 113 away from the electronic element 114 can be exposed. It may be understood that, in the embodiments of this application, "simultaneously" means being in a same step or a same process, but is not limited to being at a same moment.

In some examples, as shown in FIG. 3 and FIG. 4, before the part of the semiconductor layer 112 is removed, a carrier wafer (English: Carrier wafer) 118 may be provided, and the carrier wafer 118 is located on a side of the first dielectric layer 111 away from the semiconductor layer 112. The carrier wafer 118 may be bonded to the first dielectric layer 111 by using a material like a bonding adhesive. It may be understood that the carrier wafer 118 can play a bearing and supporting role, and reduce a risk that the semiconductor layer group 110 is broken when the part of the semiconductor layer 112 is removed.

In some other examples, the semiconductor layer group 110 may further include a functional film layer (not shown in the figure), and the functional film layer may be located on the side of the first dielectric layer 111 away from the semiconductor layer 112. It may be understood that the functional film layer can play a bearing and supporting role on the first dielectric layer 111 and the semiconductor layer 112. In this case, the carrier wafer 118 may not need to be provided, and a preparation process of the semiconductor structure 100 is simplified.

In some examples, after the semiconductor layer group 110 is provided, the semiconductor layer group 110 may be flipped, so that the second surface P2 of the semiconductor layer 112 faces upward (facing a sky side, refer to FIG. 4), to improve convenience of removing the part of the semiconductor layer 112 from the second surface P2 of the semiconductor layer 112.

In some examples, as shown in FIG. 6 and FIG. 7, there may be a plurality of conductive structures 113. A quantity of conductive structures 113 may be the same as or different from a quantity of electronic elements 114. The plurality of conductive structures 113 may be arranged in an array.

In some examples, as shown in FIG. 4, the plurality of conductive structures 113 may include a first conductive structure 113a and a second conductive structure 113b. Before the part of the semiconductor layer 112 is removed from the side of the second surface P2 of the semiconductor layer 112 along the first direction X, to expose the end face of the conductive structure 113 away from the electronic element 114, a distance L1 between an end face of the first conductive structure 113a away from the electronic element 114 and the second surface P2 of the semiconductor layer 112 is not equal to a distance L2 between an end face of the second conductive structure 113b away from the electronic element 114 and the second surface P2 of the semiconductor layer 112.

It may be understood that there may be a plurality of first conductive structures 113a, and there may also be a plurality of second conductive structures 113b. A quantity of first conductive structures 113a may be equal to or not equal to a quantity of second conductive structures 113b.

As shown in FIG. 4, before the part of the semiconductor layer 112 is removed to expose the end face of the conductive structure 113 away from the electronic element 114, the distance L1 between the end face of the first conductive structure 113a away from the electronic element 114 and the second surface P2 of the semiconductor layer 112 is not equal to the distance L2 between the end face of the second conductive structure 113b away from the electronic element 114 and the second surface P2 of the semiconductor layer 112. In other words, a length of a part of the first conductive structure 113a in the semiconductor layer 112 along the first direction X is not equal to a length of a part of the second conductive structure 113b in the semiconductor layer 112 along the first direction X.

In some examples, as shown in FIG. 4, the distance L1 between the end face of the first conductive structure 113a away from the electronic element 114 and the second surface P2 of the semiconductor layer 112 may be greater than the distance L2 between the end face of the second conductive structure 113b away from the electronic element 114 and the second surface P2 of the semiconductor layer 112. In some other examples, the distance L1 between the end face of the first conductive structure 113a away from the electronic element 114 and the second surface P2 of the semiconductor layer 112 may be less than the distance L2 between the end face of the second conductive structure 113b away from the electronic element 114 and the second surface P2 of the semiconductor layer 112.

It may be understood that removing the part of the semiconductor layer 112 from the side of the second surface P2 of the semiconductor layer 112 along the first direction X may expose the end face of one conductive structure 113 (for example, the second conductive structure 113b) away from the electronic element 114, or may expose end faces of the plurality of conductive structures 113 (for example, the first conductive structure 113a and the second conductive structure 113b) away from the electronic element 114.

For example, in step S102, removing the part of the semiconductor layer from the side of the second surface of the semiconductor layer along the first direction, to expose the end face of the conductive structure away from the electronic element includes:
removing the part of the semiconductor layer and the part of the conductive structure from the side of the second surface of the semiconductor layer along the first direction, to expose the end faces of the first conductive structure and the second conductive structure that are away from the electronic element, where the exposed end face of the first conductive structure is flush with the exposed end face of the second conductive structure.

It may be understood that, because the distance L1 between the end face of the first conductive structure 113a away from the electronic element 114 and the second surface P2 of the semiconductor layer 112 is not equal to the distance L2 between the end face of the second conductive structure 113b away from the electronic element 114 and the second surface P2 of the semiconductor layer 112, a part of the semiconductor layer 112 and a part of the conductive structure 113 (for example, the second conductive structure 113b is removed) may be removed from the side of the second surface P2 of the semiconductor layer 112 along the first direction X, as shown in FIG. 7, so that the end face of the first conductive structure 113a away from the electronic element 114 and the end face of the second conductive structure 113b away from the electronic element 114 can be exposed.

It may be understood that the end face of the first conductive structure 113a away from the electronic element 114 and the end face of the second conductive structure 113b away from the electronic element 114 can be exposed, so that another external component can be electrically connected to the first conductive structure 113a and the second conductive structure 113b, and different semiconductor structures 100 can be electrically connected through the first conductive structure 113a and the second conductive structure 113b, to meet different requirements.

In addition, the exposed end face of the first conductive structure 113a is flush with the exposed end face of the second conductive structure 113b, so that structural regularity of the semiconductor structure 100 can be improved, and processing convenience of the semiconductor structure 100 in a subsequent process can be improved.

In some examples, as shown in FIG. 6 and FIG. 7, the end faces of the plurality of conductive structures 113 away from the electronic element 114 are flush, and the end faces of the plurality of conductive structures 113 away from the electronic element 114 are flush with the second surface P2 of the semiconductor layer 112.

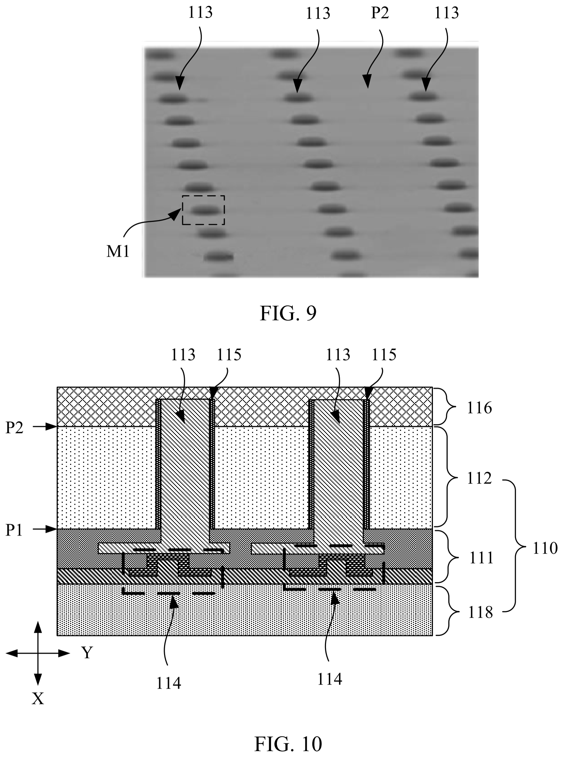

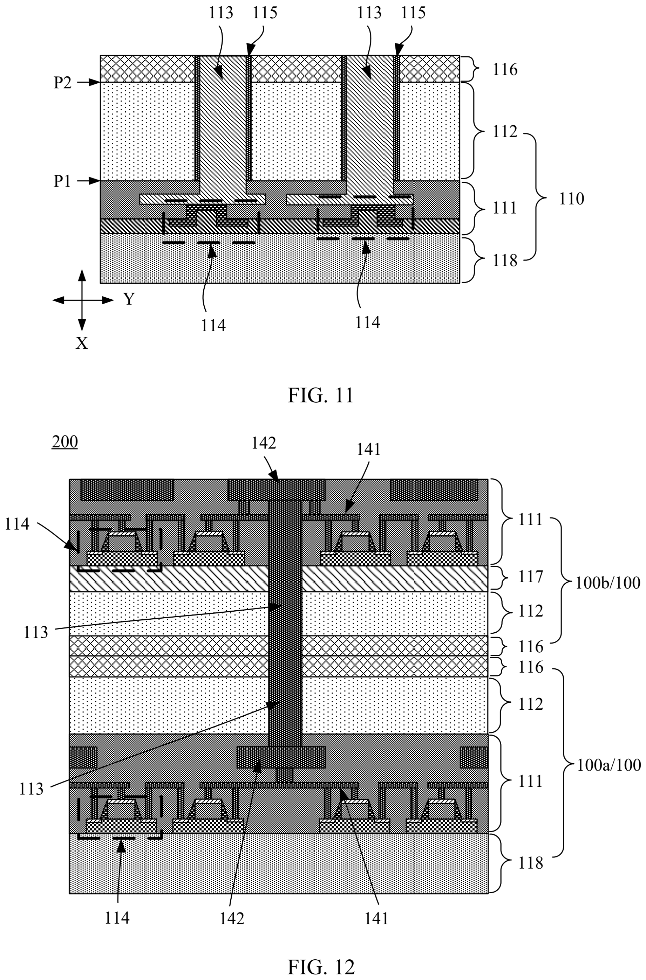

FIG. 8 is a diagram of a structure of a semiconductor layer group according to still some other embodiments of this application. FIG. 9 is a diagram of an electron microscope of a conductive structure according to some embodiments of this application. FIG. 10 is a diagram of a structure of a semiconductor layer group according to still some other embodiments of this application. FIG. 11 is a diagram of a structure of a semiconductor layer group according to still some other embodiments of this application. It may be understood that FIG. 9 is a diagram of an electron microscope of the semiconductor layer 112 observed from the side of the second surface P2 of the semiconductor layer 112.

Refer to FIG. 2 again. After the end face of the conductive structure 113 is exposed (that is, after step S102), the method for preparing the semiconductor structure 100 further includes the following steps.

Step S103: Etch a part of the semiconductor layer from the side of the second surface of the semiconductor layer along the first direction.

As shown in FIG. 8, after the end face of the conductive structure 113 is exposed, the part of the semiconductor layer 112 may be etched from the side of the second surface P2 of the semiconductor layer 112 along the first direction X, as shown in FIG. 8 and FIG. 9, so that an end part of the conductive structure 113 away from the electronic element 114 may protrude from the semiconductor layer 112.

For example, a dry etching process may be used to etch the part of the semiconductor layer 112 from the side of the second surface P2 of the semiconductor layer 112 along the first direction X; or a wet etching process may be used to etch the part of the semiconductor layer 112 from the side of the second surface P2 of the semiconductor layer 112 along the first direction X.

It may be understood that, as shown in FIG. 8, because the second dielectric layer 115 wraps the conductive structure 113, when the semiconductor layer 112 is etched to enable the end part of the conductive structure 113 away from the electronic element 114 to protrude from the semiconductor layer 112, a part of the second dielectric layer 115 away from the electronic element 114 may also protrude from the semiconductor layer 112.

Step S104: Form a third dielectric layer, where the third dielectric layer covers the second surface of the semiconductor layer and wraps an end part of the conductive structure protruding from the semiconductor layer.

As shown in FIG. 10, after the end part of the conductive structure 113 protrudes from the semiconductor layer 112, the third dielectric layer 116 may be formed. The third dielectric layer 116 covers the second surface P2 of the semiconductor layer 112 and wraps the end part of the conductive structure 113 protruding from the semiconductor layer 112.

It may be understood that the third dielectric layer 116 can be used for electrical isolation. For example, a material of the third dielectric layer 116 may be an oxide (English name: oxide), for example, silicon dioxide (chemical formula: SiO₂); or a material of the third dielectric layer 116 may be a nitride (English name: nitride), for example, silicon nitride (chemical formula: SiN); or a material of the third dielectric layer 116 may be one or a combination of a plurality of other insulation materials with a high dielectric constant. Materials of the first dielectric layer 111, the second dielectric layer 115, and the third dielectric layer 116 may be the same or different.

Step S105: Remove a part of the third dielectric layer along the first direction, to expose the end face of the conductive structure away from the electronic element.

As shown in FIG. 11, after the third dielectric layer 116 is formed, a part of the third dielectric layer 116 may be removed along the first direction X, so that the end face of the conductive structure 113 away from the electronic element 114 can be exposed.

In some examples, a CMP process may be used to remove the part of the third dielectric layer 116, so that the end face of the conductive structure 113 away from the electronic element 114 can be exposed. For example, when the part of the third dielectric layer 116 is removed, a part of the conductive structure 113 along the first direction X may be removed, to polish and flatten a surface of the third dielectric layer 116 away from the semiconductor layer 112 and the end face of the conductive structure 113 away from the electronic element 114, so that structural regularity of the semiconductor structure 100 is improved.

It may be understood that the third dielectric layer 116 can be used for electrical isolation, enhancing reliability of electrical connection of the semiconductor structure 100 when the semiconductor structure 100 is electrically connected to another component (for example, an external component or another semiconductor structure 100).

FIG. 12 is a diagram of a structure of a functional chip according to some embodiments of this application.

In some other examples, as shown in FIG. 12, when the functional chip 200 includes at least two semiconductor structures 100, the at least two semiconductor structures 100 may include a first semiconductor structure 100a and a second semiconductor structure 100b. An exposed end face of the conductive structure 113 in the first semiconductor structure 100a may be bonded to an exposed end face of the conductive structure 113 in the second semiconductor structure 100b.

It may be understood that the first semiconductor structure 100a and the second semiconductor structure 100b may be the same or different. Functions that can be implemented by the first semiconductor structure 100a may be the same as or different from functions that can be implemented by the second semiconductor structure 100b.

In some examples, as shown in FIG. 12, the electronic element 114 in the semiconductor structure 100 (for example, the first semiconductor structure 100a or the second semiconductor structure 100b) may be electrically connected to the conductive structure 113 by using a conductive trace 141 and a metal interconnection structure 142. For example, materials of the conductive trace 141, the metal interconnection structure 142, and the conductive structure 113 are the same. In some other examples, materials of the conductive trace 141, the metal interconnection structure 142, and the conductive structure 113 may be different.

In some examples, the semiconductor structure 100 (for example, the second semiconductor structure 100b) may further include a buried oxide (English full name: Buried Oxide, English abbreviation: BOX) 117. The buried oxide 117 may be located between the first dielectric layer 111 and the semiconductor layer 112, and is used for electrical isolation. For example, a material of the buried oxide 117 may include silicon dioxide.

It may be understood that the exposed end face of the conductive structure 113 in the first semiconductor structure 100a (that is, the end face of the conductive structure 113 away from the electronic element 114 in the first semiconductor structure 100a) is bonded to the exposed end face of the conductive structure 113 in the second semiconductor structure 100b (that is, the end face of the conductive structure 113 away from the electronic element 114 in the second semiconductor structure 100b), so that when the first semiconductor structure 100a and the second semiconductor structure 100b are stacked, the electronic element 114 in the first semiconductor structure 100a can be electrically connected to the electronic element 114 in the second semiconductor structure 100b. This implements inter-layer interconnection of a bonded wafer, and enables the functional chip 200 to become a 3D IC.

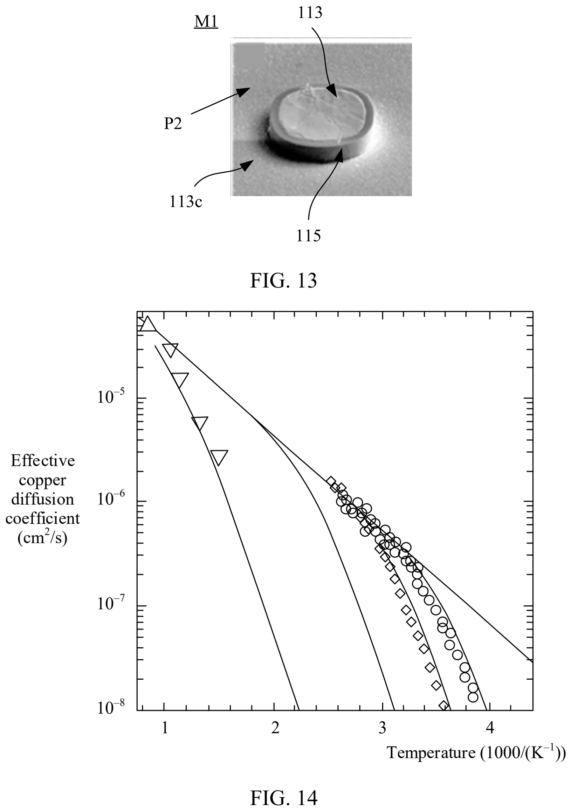

FIG. 13 is a locally enlarged diagram of a region M1 in FIG. 9.

The inventor of this application finds that the foregoing implementation has at least the following technical problems.

In the related technology, when a TSV process is used to form the conductive structure 113, according to different process sequences, the TSV processes may be classified into via-first (Chinese name: via-first), via-middle (Chinese name: via-middle), or via-last (via-last) manner.

Via-first means that the conductive structure 113 is formed before a front end of the line (English full name: Front End Of The Line, English abbreviation: FEOL) process. Via-middle means that the conductive structure 113 is formed after the front end of the line process and before a back end of the line (English full name: Back End Of The Line, English abbreviation: BEOL) process. Via-last means that the conductive structure 113 is formed after the back end of the line process.

In the foregoing three manners, via-first and via-middle are more common. However, regardless of whether the via-first process or the via-middle process is used, the part of the semiconductor layer 112 is removed from the side of the second surface P2 of the semiconductor layer 112 along the first direction X, so that the end face of the conductive structure 113 away from the electronic element 114 is exposed, and then a part of the semiconductor layer 112 is etched (refer to steps S102 and S103 in FIG. 2).

In this way, when the part of the semiconductor layer 112 is etched, the end face of the conductive structure 113 away from the electronic element 114 is exposed, so that the etching ion beam directly bombards the exposed end face of the conductive structure 113. The conductive structure 113 splashes metal particles under bombardment of the ion beam, and the metal particles fall on the second surface P2 of the semiconductor layer 112.

For example, the material of the conductive structure 113 is copper, and the material of the semiconductor layer 112 is silicon. The etching ion beam directly bombards a copper surface. Under bombardment of the ion beam, the conductive structure 113 splashes out copper particles 113c. As shown in FIG. 13, the copper particles 113c fall on the second surface P2 of the semiconductor layer 112, causing a serious copper contamination issue (English full name: Cu Contamination Issue) to the semiconductor layer 112. However, it is difficult to remove copper contamination of the semiconductor layer 112 in a subsequent cleaning process. The copper particles 113c easily diffuse in the semiconductor layer 112, affecting electrical reliability of the semiconductor structure 100.

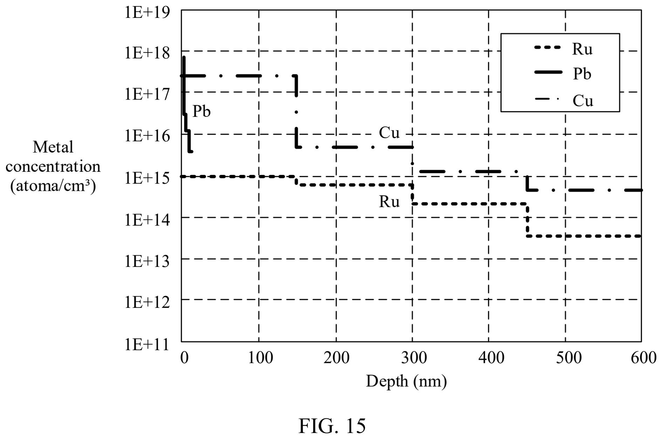

FIG. 14 is a diagram of a curve in which an effective copper diffusion coefficient changes with a temperature. FIG. 15 is a diagram of diffusion depth curves of different metals in a same medium.

In FIG. 14, a vertical coordinate represents an effective copper diffusion coefficient (English full name: Effective Copper Diffusion Coefficient), for example, may be an effective copper diffusion coefficient in silicon, and a unit is square centimeter per second (cm²/s). A horizontal coordinate represents a temperature, and a unit is 1000/T (K⁻¹). Different curves represent different experimental data.

It can be seen from FIG. 14 that effective copper diffusion coefficients in silicon are different at different temperatures. However, at each temperature, copper atom migration coefficients (effective diffusion coefficients) in silicon are high.

**Table 1**

| Metal | Frequency factor D₀ (m²/s) | Activation energy Q (kJ/mol) | Self-diffusion coefficient D (m²/s) |
|---|---|---|---|
| Ti^{a} (titanium alloy) | | 125 | 3.5×10⁻²⁵ |
| AL (aluminum) | 1.7×10⁻⁴ | 142 | 3.3×10⁻²⁹ |
| Au (gold) | 1.1×10⁻⁵ | 177 | 1.6×10⁻³⁶ |
| Ag (silver) | 6.7×10⁻⁵ | 189 | 8.3×10⁻³⁸ |
| Cu (copper) | 7.8×10⁻⁵ | 211 | 1.4×10⁻⁴¹ |
| Co (cobalt) | 2.3×10⁻⁵ | 268 | 5.0×10⁻⁵² |
| Ni (nickel) | 1.3×10⁻⁴ | 281 | 1.5×10⁻⁵³ |
| Pt (platinum) | 2.2×10⁻⁵ | 278 | 8.7×10⁻⁵⁴ |
| Fe (iron) | 1×10⁻⁴ | 294 | 6.5×10⁻⁵⁶ |
| Cr (chromium) | 2×10⁻⁵ | 308 | 4.7×10⁻⁵⁹ |
| Ru (ruthenium) | - | - | (10⁻⁷⁰) |
| Mo (molybdenum) | 1×10⁻⁵ | 386 | 6.2×10⁻⁷³ |
| Ta (tantalum) | 1.2×10⁻⁵ | 413 | 1.5×10⁻⁷⁷ |

Table 1 shows self-diffusion coefficients D, frequency factors D₀, and activation energy Q of different metals in silicon at a same temperature (300 K, unit: Kelvin).

It can be learned from Table 1 that, compared with other metal elements, copper has a higher self-diffusion coefficient D in silicon. For example, at the temperature of 300 K, a copper self-diffusion coefficient in silicon is as high as 1.4x10⁻⁴¹ cm²/s, which is more than a dozen orders of magnitude higher than that of other common metals, such as Co, Ni, and Pt.

FIG. 15 shows depth distribution of etched Ru, Pb, and Cu in silicon after annealing for one hour in a nitrogen environment at 400°C (unit: Celsius). In FIG. 15, a vertical coordinate represents metal concentration (English: Metallic concentration), and a unit is atoms per cubic centimeter (atoma/cm³); and a horizontal coordinate represents a depth (English: Depth), and a unit is nanometers (nm). Different curves represent different metals.

It can be seen from FIG. 15 that, at the same contamination concentration (metal concentration), a diffusion depth of copper is far higher than that of other metals (Ru and Pb).

It can be seen from the foregoing data that after the copper particles falls on the second surface P2 of the semiconductor layer 112, the copper particles quickly diffuse in the semiconductor layer 112, affecting electrical reliability of the semiconductor structure 100.

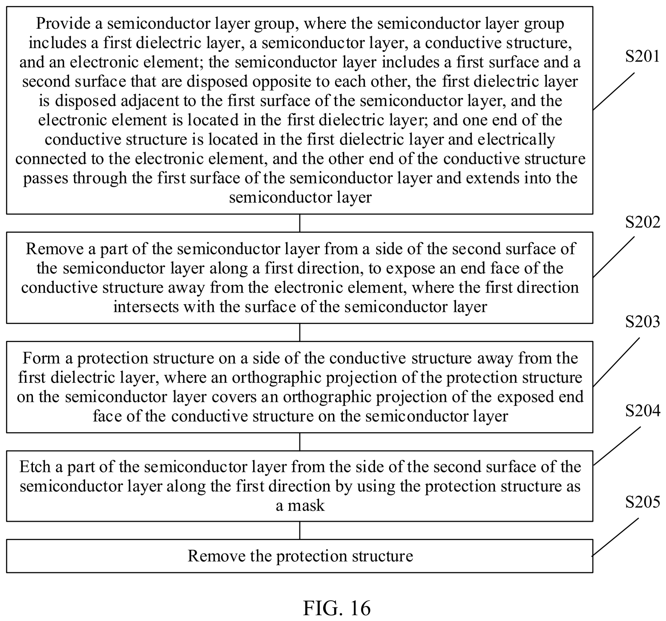

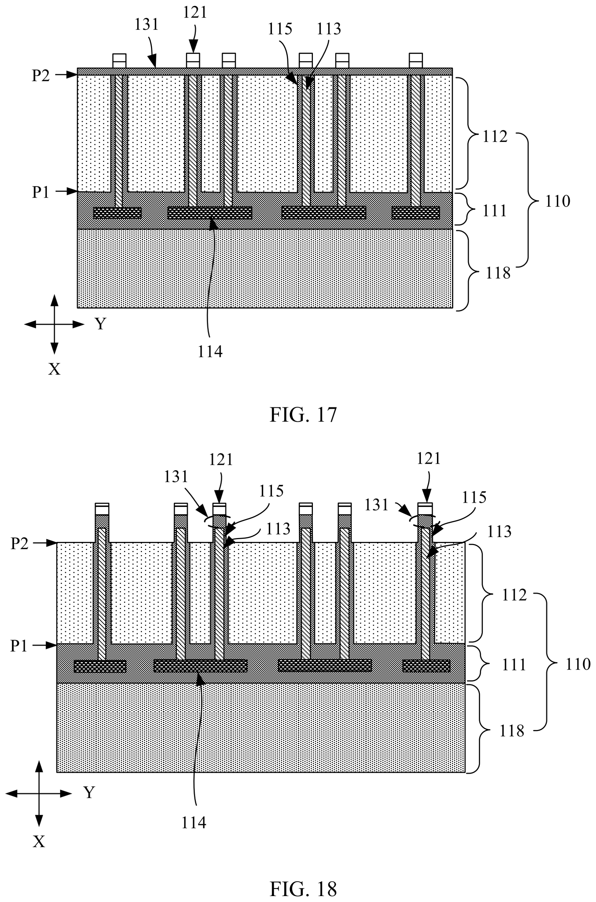

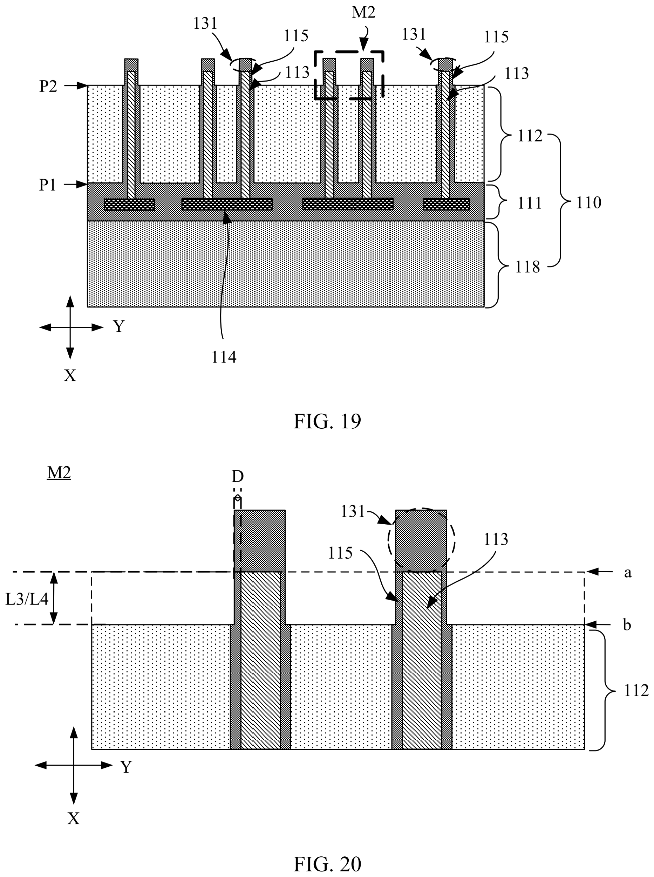

FIG. 16 is a flowchart of steps of a method for preparing a semiconductor structure according to some other embodiments of this application. FIG. 17 is a diagram of a structure of a semiconductor layer group according to still some other embodiments of this application. FIG. 18 is a diagram of a structure of a semiconductor layer group according to still some other embodiments of this application. FIG. 19 is a diagram of a structure of a semiconductor layer group according to still some other embodiments of this application. FIG. 20 is a locally enlarged diagram of a region M2 in FIG. 19.

In view of this, an embodiment of this application provides a method for preparing a semiconductor structure.

As shown in FIG. 16, the method for preparing the semiconductor structure includes the following steps.
Step S201: Provide a semiconductor layer group, where the semiconductor layer group includes a first dielectric layer, a semiconductor layer, a conductive structure, and an electronic element; the semiconductor layer includes a first surface and a second surface that are disposed opposite to each other, the first dielectric layer is disposed adjacent to the first surface of the semiconductor layer, and the electronic element is located in the first dielectric layer; and one end of the conductive structure is located in the first dielectric layer and electrically connected to the electronic element, and the other end of the conductive structure passes through the first surface of the semiconductor layer and extends into the semiconductor layer;
Step S202: Remove a part of the semiconductor layer from a side of the second surface of the semiconductor layer along a first direction, to expose an end face of the conductive structure away from the electronic element, where the first direction intersects the surface of the semiconductor layer;

It may be understood that step S201 is the same as step S101, and step S202 is the same as step S102. The foregoing embodiments of this application have described step S101 and step S102 by using examples. Details are not described herein again.

Step S203: Form a protection structure on a side of the conductive structure away from the first dielectric layer, where an orthographic projection of the protection structure on the semiconductor layer covers an orthographic projection of the exposed end face of the conductive structure on the semiconductor layer.

It may be understood that the protection structure 121 is located on the side of the conductive structure 113 away from the first dielectric layer 111, and the orthographic projection of the protection structure 121 on the semiconductor layer 112 covers the orthographic projection of the exposed end face of the conductive structure 113 (namely, the end face of the conductive structure 113 away from the electronic element 114) on the semiconductor layer 112. In this way, the protection structure 121 can cover the end face of the conductive structure 113 away from the electronic element 114.

In some examples, the orthographic projection of the protection structure 121 on the semiconductor layer 112 may completely cover the orthographic projection of the exposed end face of the conductive structure 113 on the semiconductor layer 112. In some other examples, the orthographic projection of the protection structure 121 on the semiconductor layer 112 may partially cover the orthographic projection of the exposed end face of the conductive structure 113 on the semiconductor layer 112.

In some examples, the orthographic projection of the protection structure 121 on the semiconductor layer 112 overlays (English full name: Overlay, English abbreviation: OVL) the orthographic projection of the exposed end face of the conductive structure 113 on the semiconductor layer 112, and a distance between a center of the orthographic projection of the protection structure 121 on the semiconductor layer 112 and a center of the orthographic projection of the conductive structure 113 on the semiconductor layer 112 is less than 100 nm. In this way, a deviation between the orthographic projection of the protection structure 121 on the semiconductor layer 112 and the orthographic projection of the exposed end face of the conductive structure 113 on the semiconductor layer 112 can be reduced, and reliability of the method for preparing the semiconductor structure 100 can be improved.

For example, a shape of the protection structure 121 may be a cylinder, a truncated cone, a cone, a prism, a truncated prism, a cuboid, a cube, or another irregular shape. The shape of the protection structure 121 is not further limited in embodiments of this application.

For example, when the shape of the protection structure 121 is the cylinder, a shape of an orthographic projection of the cylinder on the semiconductor layer 112 is a shape of an orthographic projection of a bottom face of the cylinder on the semiconductor layer 112. When the shape of the protection structure 121 is the truncated cone, a shape of an orthographic projection of the truncated cone on the semiconductor layer 112 is a shape of an orthographic projection of a lower bottom face of the truncated cone on the semiconductor layer 112. An upper bottom face of the truncated cone is parallel to the lower bottom face, and an area of the upper bottom face is less than an area of the lower bottom face. When the shape of the protection structure 121 is the cone, a shape of an orthographic projection of the cone on the semiconductor layer 112 is a shape of an orthographic projection of a bottom face of the cone on the semiconductor layer 112.

It may be understood that a shape of the orthographic projection of the protection structure 121 on the semiconductor layer 112 may be the same as or different from a shape of the orthographic projection of the end face of the conductive structure 113 away from the electronic element 114 on the semiconductor layer 112. In some examples, the shape of the orthographic projection of the protection structure 121 on the semiconductor layer 112 and the shape of the orthographic projection of the end face of the conductive structure 113 away from the electronic element 114 on the semiconductor layer 112 are both a circle.

In some examples, a quantity of protection structures 121 is the same as a quantity of conductive structures 113, and the orthographic projection of one protection structure 121 on the semiconductor layer 112 covers an orthographic projection of an exposed end face of one conductive structure 113 on the semiconductor layer 112. In some other examples, a quantity of protection structures 121 may be less than a quantity of conductive structures 113, and an orthographic projection of one protection structure 121 on the semiconductor layer 112 covers orthographic projections of exposed end faces of at least two conductive structures 113 on the semiconductor layer 112.

In some examples, as shown in FIG. 17, another film layer (for example, the isolation layer 131) may be disposed between the protection structure 121 and the exposed end face of the conductive structure 113. In some other examples, the protection structure 121 and the exposed end face of the conductive structure 113 may be disposed adjacent to each other.

Refer to FIG. 16 again. After step S203, the method for preparing the semiconductor structure further includes the following steps.

Step S204: Etch a part of the semiconductor layer from the side of the second surface of the semiconductor layer along the first direction by using the protection structure as a mask.

It may be understood that because the orthographic projection of the protection structure 121 on the semiconductor layer 112 covers the orthographic projection of the end face of the conductive structure 113 away from the electronic element 114 on the semiconductor layer 112, the protection structure 121 can protect the exposed end face of the conductive structure 113.

For example, a dry etching process may be used to etch the part of the semiconductor layer 112, or a wet etching process may be used to etch the part of the semiconductor layer 112.

When the protection structure 121 is used as the mask to etch the semiconductor layer 112, the end face of the conductive structure 113 away from the electronic element 114 is not exposed. This avoids a case in which metal particles fall on the second surface P2 of the semiconductor layer 112 because the conductive structure 113 is bombarded by an etching ion beam, reduces metal pollution caused by the conductive structure 113 to the semiconductor layer 112, and improves electrical reliability of the semiconductor structure 100.

Step S205: Remove the protection structure.

As shown in FIG. 18, after the part of the semiconductor layer 112 is etched from a side of the second surface P2 of the semiconductor layer 112 along the first direction X by using the protection structure 121 as the mask, an end part of the conductive structure 113 away from the electronic element 114 can protrude from the semiconductor layer 112. In this case, the protection structure 121 may be removed, as shown in FIG. 19, to avoid impact of the protection structure 121 on a subsequent processing process.

For example, the protection structure 121 may be removed through cleaning.

In this embodiment of this application, the protection structure 121 is formed on the side of the conductive structure 113 away from the first dielectric layer 111. The orthographic projection of the protection structure 121 on the semiconductor layer 112 covers the orthographic projection of the exposed end face (namely, the end face of the conductive structure 113 away from the electronic element 114) of the conductive structure 113 on the semiconductor layer 112. In this way, the protection structure 121 can cover the end face of the conductive structure 113 away from the electronic element 114.

In this way, the protection structure 121 can be used as the mask. When the part of the semiconductor layer 112 is etched from the side of the second surface P2 of the semiconductor layer 112 along the first direction X, the etching ion beam does not bombard the end face of the conductive structure 113 away from the electronic element 114. This reduces a risk that metal particles fall on the second surface P2 of the semiconductor layer 112 because the conductive structure 113 splashes under action of the etching ion beam when the part of the semiconductor layer 112 is etched. In this way, residual of the conductive metal particles can be reduced, metal pollution caused by the conductive structure 113 to the semiconductor layer 112 is reduced, and electrical reliability of the semiconductor structure 100 is improved.

In addition, after the part of the semiconductor layer 112 is etched, the protection structure 121 is removed, to avoid impact of the protection structure 121 on a subsequent processing process.

In some examples, when the part of the semiconductor layer is etched from the side of the second surface of the semiconductor layer along the first direction by using the protection structure as the mask (that is, at the same time as step S204), the method further includes:
etching a first part of a second dielectric layer, where the first part of the second dielectric layer wraps an outer peripheral side of an end part of the conductive structure away from the electronic element, and is away from the conductive structure in a second direction, and the second direction is parallel to the surface of the semiconductor layer.

It may be understood that the first direction X intersects the surface of the semiconductor layer 112, and the second direction Y is parallel to the surface of the semiconductor layer 112. In this way, the first direction X can intersect the second direction Y. In some examples, the first direction X and the second direction Y are orthogonal.

For example, as shown in FIG. 19 and FIG. 20, when the semiconductor layer 112 is etched, the first part of the second dielectric layer 115 may be etched, that is, a part that is of the second dielectric layer 115 wrapping the outer peripheral side of the end part of the conductive structure 113 away from the electronic element 114 and that is away from the conductive structure 113 in the second direction Y is etched.

It may be understood that, as shown in FIG. 20, before the semiconductor layer 112 is etched, the second surface P2 of the semiconductor layer 112 is located at a first position a. After the semiconductor layer 112 is etched, the second surface P2 of the semiconductor layer 112 is located at a second position b. A distance between the first position a and the second position b is a third distance L3, that is, a thickness of the semiconductor layer 112 that is etched along the first direction X is the third distance L3. A length of the part of the second dielectric layer 115 that is etched along the first direction X is a fourth distance L4. As shown in FIG. 20, the third distance L3 is equal to the fourth distance L4.

The first part of the second dielectric layer 115 is etched when the semiconductor layer 112 is etched. This can reduce a risk that the semiconductor layer 112 remains on a surface of the second dielectric layer 115 away from the conductive structure 113 because the semiconductor layer 112 is adhered to the second dielectric layer 115, and improve reliability of a method for preparing a semiconductor structure.

In addition, the part that is of the second dielectric layer 115 wrapping the outer peripheral side of the end part of the conductive structure 113 away from the electronic element 114 and that is close to the conductive structure 113 in the second direction Y is not removed through etching. For example, the part of the second dielectric layer 115 may be referred to as a second part of the second dielectric layer 115.

The second part of the second dielectric layer 115 can protect the outer peripheral side of the end part of the conductive structure 113 away from the electronic element 114. In other words, the protection structure 121 can protect the end face of the conductive structure 113 away from the electronic element 114, and the second part of the second dielectric layer 115 can protect the outer peripheral side of the end part of the conductive structure 113 away from the electronic element 114, to prevent an etching ion beam from bombarding the end part (including the end face and the outer peripheral side) of the conductive structure 113 away from the electronic element 114 when the semiconductor layer 112 is etched. This reduces metal pollution caused by the conductive structure 113 to the semiconductor layer 112, and improves electrical reliability of the semiconductor structure 100.

In some examples, as shown in FIG. 20, the thickness D of the second part of the second dielectric layer 115 may be half of a thickness of the second dielectric layer 115 that is not etched. In some other examples, the thickness D of the second part of the second dielectric layer 115 may be greater than or less than half of a thickness of the second dielectric layer 115 that is not etched. It may be understood that a value of the thickness D of the second part of the second dielectric layer 115 is not further limited in embodiments of this application.

In some examples, thicknesses D of a second part of the second dielectric layer 115 adjacent to different positions of the conductive structure 113 may be different.

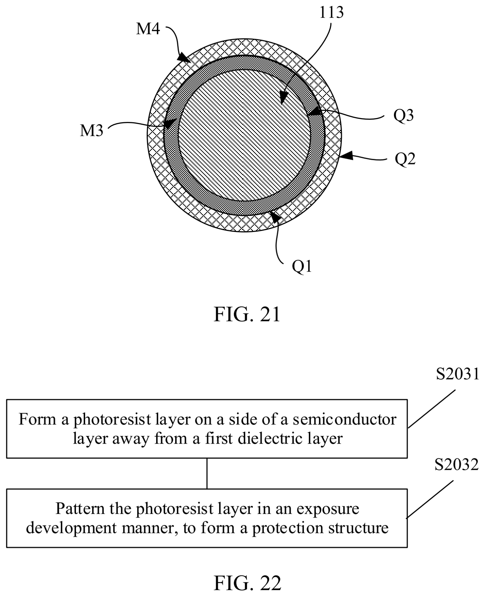

FIG. 21 is a diagram of a position relationship between an edge of an orthographic projection of a protection structure on a semiconductor layer and an orthographic projection of a second dielectric layer on the semiconductor layer according to some embodiments of this application.

In some examples, an edge Q1 of the orthographic projection of the protection structure 121 on the semiconductor layer 112 is located between an orthographic projection Q2 of a surface of the second dielectric layer 115 away from the conductive structure 113 on the semiconductor layer 112 and an orthographic projection Q3 of a surface of the second dielectric layer 115 close to the conductive structure 113 on the semiconductor layer 112.

For example, a shape of the orthographic projection of the protection structure 121 on the semiconductor layer 112 is a circle, a shape of the orthographic projection of the end face of the conductive structure 113 away from the electronic element 114 on the semiconductor layer 112 is a circle, and a shape of the orthographic projection of the second dielectric layer 115 on the semiconductor layer 112 is an annulus. As shown in FIG. 21, the second dielectric layer 115 wraps the conductive structure 113, so that the orthographic projection of the conductive structure 113 on the semiconductor layer 112 can be located within the orthographic projection of the second dielectric layer 115 on the semiconductor layer 112.

The edge Q1 of the orthographic projection of the protection structure 121 on the semiconductor layer 112 is located between the orthographic projection Q2 of the surface of the second dielectric layer 115 away from the conductive structure 113 on the semiconductor layer 112 and the orthographic projection Q3 of the surface of the second dielectric layer 115 close to the conductive structure 113 on the semiconductor layer 112, so that the protection structure 121 can cover the end face of the conductive structure 113 away from the electronic element 114 and the second part of the second dielectric layer 115 (refer to a region M3 in FIG. 21).

It may be understood that the protection structure 121 can protect the second part of the second dielectric layer 115 and the end face that is of the conductive structure 113 away from the electronic element 114 and that is covered by the protection structure 121, and the first part that is of the second dielectric layer 115 and that is not covered by the protection structure 121 can be removed through etching (refer to the region M4 in FIG. 21).

In other words, in the foregoing disposing manner, the protection structure 121 can protect the end face of the conductive structure 113 away from the electronic element 114 and the second part of the second dielectric layer 115, and the first part of the second dielectric layer 115 can be removed through etching. This reduces a risk that the semiconductor layer 112 remains on the surface of the second dielectric layer 115 away from the conductive structure 113 because the semiconductor layer 112 is adhered to the second dielectric layer 115, and improves reliability of a method for preparing the semiconductor structure.

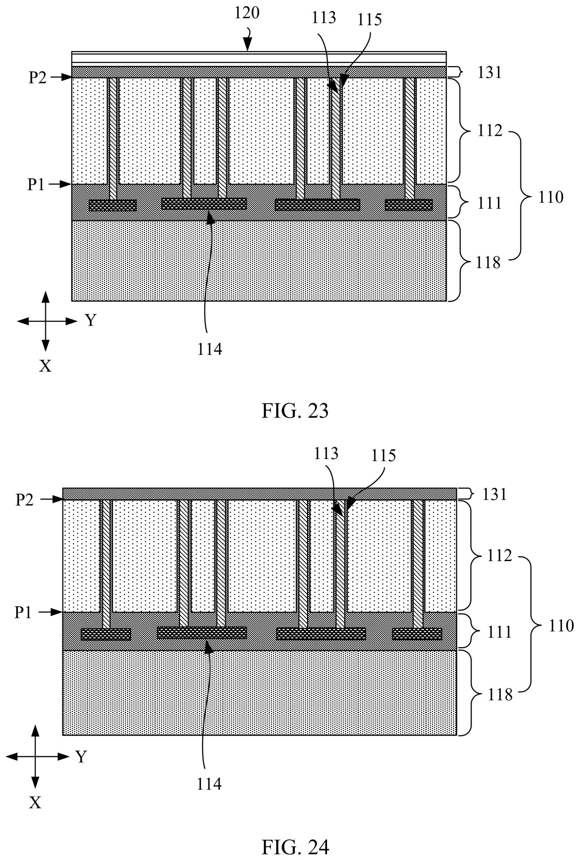

FIG. 22 is a flowchart of steps of a method for preparing a semiconductor structure according to still some other embodiments of this application. FIG. 23 is a diagram of a structure of a semiconductor layer group according to still some other embodiments of this application. FIG. 24 is a diagram of a structure of a semiconductor layer group according to still some other embodiments of this application.

In some examples, as shown in FIG. 22, forming the protection structure on the side of the conductive structure away from the first dielectric layer (that is, step S203) includes the following steps.

Step S2031: Form a photoresist layer on a side of the semiconductor layer away from the first dielectric layer.

As shown in FIG. 23, a photoresist layer (English full name: Photoresist, English abbreviation: PR) 120 may be formed on a side of the semiconductor layer 112 away from the first dielectric layer 111. In some examples, as shown in FIG. 23, another film layer structure may be disposed between the photoresist layer 120 and the second surface P2 of the semiconductor layer 112. In some other examples, the photoresist layer 120 may be disposed adjacent to the second surface P2 of the semiconductor layer 112.

In some examples, a printing process may be used to form the photoresist layer 120 on a side of the isolation layer 131 away from the semiconductor layer 112.

Step S2032: Pattern the photoresist layer in an exposure development manner, to form the protection structure.

For example, a photomask (English: mask) may be disposed between a light source and the photoresist layer 120. Light passes through a pattern on the mask and is irradiated onto the photoresist layer 120, so that the photoresist layer 120 can be patterned, to form the protection structure 121 (refer to FIG. 17).

In some examples, a positive development photoresist layer may be used. In some other examples, a negative development photoresist layer may alternatively be used.

It may be understood that the photoresist layer 120 is patterned in an exposure development manner to form the protection structure 121. This does not require a complex preparation method. On a basis of improving electrical performance of the semiconductor structure 100, a preparation process of the semiconductor structure 100 is simplified, and preparation costs of the semiconductor structure 100 are reduced.

Before the photoresist layer is formed on the side of the semiconductor layer away from the first dielectric layer, the method includes:
forming an isolation layer on the side of the second surface of the semiconductor layer, where the isolation layer covers the semiconductor layer and the exposed end face of the conductive structure.

As shown in FIG. 24, before the photoresist layer 120 is formed, the isolation layer 131 is formed on the side of the second surface P2 of the semiconductor layer 112. For example, the isolation layer 131 may be disposed adjacent to the second surface P2 of the semiconductor layer 112, so that the isolation layer 131 can cover the semiconductor layer 112 and the exposed end face of the conductive structure 113 (namely, the end face of the conductive structure 113 away from the electronic element 114). The photoresist layer 120 may be located on the side of the isolation layer 131 away from the semiconductor layer 112.

It may be understood that the isolation layer 131 can be used for isolation. For example, a material of the isolation layer 131 may be an oxide (English name: oxide), for example, silicon dioxide (chemical formula: SiO₂); or a material of the isolation layer 131 may be a nitride (English name: nitride), for example, silicon nitride (chemical formula: SiN); or a material of the isolation layer 131 may be one or a combination of a plurality of other insulation materials with a high dielectric constant. Materials of the first dielectric layer 111, the second dielectric layer 115, the third dielectric layer 116, and the isolation layer 131 may be the same or different. A material of the isolation layer 131 is not further limited in embodiments of this application.

For example, the conductive structure 113 is a cylinder, a diameter of a bottom surface of the cylinder is 5 µm, and a height of the cylinder is 50 µm. In this case, a thickness of the isolation layer 131 may be 2000 Å (unit: Å). In some examples, a larger size of the conductive structure 113 indicates a larger thickness of the isolation layer 131. A smaller size of the conductive structure 113 indicates a smaller thickness of the isolation layer 131. A thickness of the isolation layer 131 is not further limited in embodiments of this application.

It may be understood that the isolation layer 131 is formed before the photoresist layer 120 is formed, so that the isolation layer 131 can isolate the photoresist layer 120 from the end face of the conductive structure 113 away from the electronic element 114, to avoid contact between the photoresist layer 120 and the end face of the conductive structure 113 away from the electronic element 114, and avoid pollution of the end face of the conductive structure 113 away from the electronic element 114 by the photoresist layer 120, and improve electrical reliability of the semiconductor structure 100.

In some examples, before the part of the semiconductor layer is etched from the side of the second surface of the semiconductor layer along the first direction by using the protection structure as the mask (that is, before step S204), the method further includes:
etching, by using the protection structure as the mask, a part of the semiconductor layer that is covered by the isolation layer.

Refer again to FIG. 17. Because the isolation layer 131 covers the second surface P2 of the semiconductor layer 112 and the exposed end face of the conductive structure 113, before the semiconductor layer 112 is etched, the part of the semiconductor layer 112 that is covered by the isolation layer 131 needs to be etched by using the protection structure 121 as the mask, so that the semiconductor layer 112 can be exposed, thereby avoiding impact of the isolation layer 131 on a subsequent process.

In an example, etching the part of the semiconductor layer 112 that is covered by the isolation layer 131 and etching the semiconductor layer 112 may be in a same step.

Refer to FIG. 18. After the part of the semiconductor layer 112 that is covered by the isolation layer 131 is etched, a remaining part of the isolation layer 131 covers the end face of the conductive structure 113 away from the electronic element 114. In some examples, the orthographic projection of the protection structure 121 on the semiconductor layer 112 coincides with an orthographic projection of the remaining part of the isolation layer 131 on the semiconductor layer 112.

In some examples, as shown in FIG. 19 and FIG. 20, after the part of the semiconductor layer 112 that is covered by the isolation layer 131 and a part of the semiconductor layer 112 are etched, the protection structure 121 may be removed.

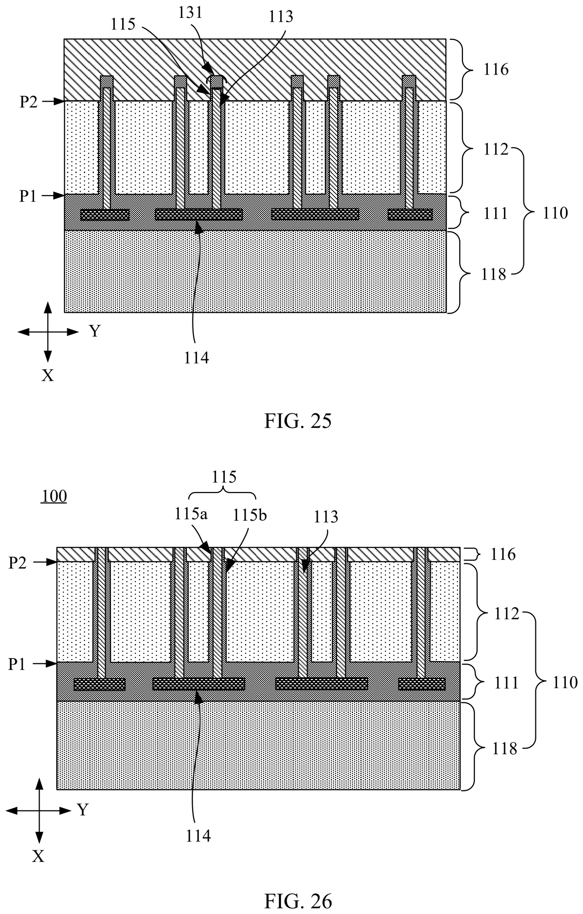

FIG. 25 is a diagram of a structure of a semiconductor layer group according to still some other embodiments of this application. FIG. 26 is a diagram of a structure of a semiconductor structure according to some embodiments of this application.

In some examples, after removing the protection structure (that is, after step S205), the method further includes:
forming a third dielectric layer, where the third dielectric layer covers the second surface of the semiconductor layer and wraps an end part of the conductive structure protruding from the semiconductor layer.

It may be understood that the foregoing embodiments of this application have described an example of the material of the third dielectric layer 116. Details are not described herein again.

As shown in FIG. 25, the third dielectric layer 116 is located on the side of the semiconductor layer 112 away from the first dielectric layer 111, so that the third dielectric layer 116 can cover the semiconductor layer 112 and wrap the end part of the conductive structure 113 protruding from the semiconductor layer 112. In some examples, the third dielectric layer 116 may be disposed adjacent to the second surface P2 of the semiconductor layer 112.

A part of the third dielectric layer and the isolation layer are removed along the first direction, to expose an end face of the conductive structure.

It may be understood that after the third dielectric layer 116 is formed, a part of the third dielectric layer 116 and the isolation layer 131 covering the end face of the conductive structure 113 away from the electronic element 114 may be removed along the first direction X, as shown in FIG. 26, so that the end face of the conductive structure 113 away from the electronic element 114 can be exposed. For example, the end face of the conductive structure 113 away from the electronic element 114 is flush with a surface of the third dielectric layer 116 away from the semiconductor layer 112.

In some examples, a CMP process may be used to remove the part of the third dielectric layer 116 and the isolation layer 131 covering the end face of the conductive structure 113 away from the electronic element 114. For example, when the part of the third dielectric layer 116 and the isolation layer 131 covering the end face of the conductive structure 113 away from the electronic element 114 are removed, a part of the conductive structure 113 along the first direction X may be removed, to polish and flatten the surface of the third dielectric layer 116 away from the semiconductor layer 112 and the end face of the conductive structure 113 away from the electronic element 114, so that structural regularity of the semiconductor structure 100 is improved.

It may be understood that the third dielectric layer 116 is removed along the first direction X, so that the end face of the conductive structure 113 away from the electronic element 114 can be exposed, and another component (for example, an external component or another semiconductor structure 100) can be electrically connected to the semiconductor structure 100 through the conductive structure 113. In addition, the third dielectric layer 116 is used for electrical isolation, enhancing reliability of electrical connection between the semiconductor structure 100 and another component.

In another aspect, an embodiment of this application provides a semiconductor structure 100. As shown in FIG. 26, the semiconductor structure 100 may include a semiconductor layer group 110 and a third dielectric layer 116.

For example, as shown in FIG. 26, the semiconductor layer group 110 may include a first dielectric layer 111, a semiconductor layer 112, a second dielectric layer 115, a conductive structure 113, and an electronic element 114. The semiconductor layer 112 includes a first surface P1 and a second surface P2 that are disposed opposite to each other. The first dielectric layer 111 is disposed adjacent to the first surface P1 of the semiconductor layer 112. The electronic element 114 is located in the first dielectric layer 111. One end of the conductive structure 113 is located in the first dielectric layer 111 and is electrically connected to the electronic element 114. The second dielectric layer 115 wraps the conductive structure 113.

The third dielectric layer 116 is disposed adjacent to the second surface P2 of the semiconductor layer 112. An end of the conductive structure 113 away from the electronic element 114 passes through the semiconductor layer 112 and the third dielectric layer 116, and an end face of the conductive structure 113 away from the electronic element 114 is exposed in the third dielectric layer 116.

It may be understood that the foregoing embodiments of this application have described examples of materials and a position relationship of the semiconductor layer group 110 and the third dielectric layer 116. Details are not described herein again.

For example, as shown in FIG. 26, the second dielectric layer 115 includes a first subpart 115a and a second subpart 115b. The first subpart 115a is located between the third dielectric layer 116 and the conductive structure 113, and the second subpart 115b is located between the semiconductor layer 112 and the conductive structure 113. A thickness of the first subpart 115a is less than a thickness of the second subpart 115b.

It may be understood that a first part of the second dielectric layer 115 is etched when the semiconductor layer 112 is etched. Therefore, a thickness of a remaining part of the second dielectric layer 115 (a second part of the second dielectric layer 115, namely, the first subpart 115a) after etching can be less than a thickness of the second dielectric layer 115 that is not etched.

In this way, a risk that a surface of the first subpart 115a away from the conductive structure 113 is adhered to the semiconductor layer 112 can be reduced, and electrical reliability of the semiconductor structure 100 can be improved.

In conclusion, embodiments of this application have at least the following beneficial effect.

In this embodiment of this application, the protection structure 121 is formed on the side of the conductive structure 113 away from the first dielectric layer 111. The orthographic projection of the protection structure 121 on the semiconductor layer 112 covers the orthographic projection of the exposed end face (namely, the end face of the conductive structure 113 away from the electronic element 114) of the conductive structure 113 on the semiconductor layer 112. In this way, the protection structure 121 can cover the end face of the conductive structure 113 away from the electronic element 114.

In this way, the protection structure 121 can be used as the mask. When the part of the semiconductor layer 112 is etched from the side of the second surface P2 of the semiconductor layer 112 along the first direction X, the etching ion beam does not bombard the end face of the conductive structure 113 away from the electronic element 114. This reduces a risk that metal particles fall on the second surface P2 of the semiconductor layer 112 because the conductive structure 113 splashes under action of the etching ion beam when the part of the semiconductor layer 112 is etched. In this way, residual of the conductive metal particles can be reduced, metal pollution caused by the conductive structure 113 to the semiconductor layer 112 is reduced, and electrical reliability of the semiconductor structure 100 is improved.

In addition, after the part of the semiconductor layer 112 is etched, the protection structure 121 is removed, to avoid impact of the protection structure 121 on a subsequent processing process.

The foregoing descriptions are merely specific implementations of this application, but are not intended to limit the protection scope of this application. Any variation or replacement figured out by a person skilled in the art within the technical scope disclosed in this application shall fall within the protection scope of this application. Therefore, the protection scope of this application shall be subject to the protection scope of the claims.

## Claims

1. A method for preparing a semiconductor structure, comprising:
providing a semiconductor layer group, wherein the semiconductor layer group comprises a first dielectric layer, a semiconductor layer, a conductive structure, and an electronic element; the semiconductor layer comprises a first surface and a second surface that are disposed opposite to each other, the first dielectric layer is disposed adjacent to the first surface of the semiconductor layer, and the electronic element is located in the first dielectric layer; and one end of the conductive structure is located in the first dielectric layer and electrically connected to the electronic element, and the other end of the conductive structure passes through the first surface of the semiconductor layer and extends into the semiconductor layer;
removing a part of the semiconductor layer from a side of the second surface of the semiconductor layer along a first direction, to expose an end face of the conductive structure away from the electronic element, wherein the first direction intersects the surface of the semiconductor layer;
forming a protection structure on a side of the conductive structure away from the first dielectric layer, wherein an orthographic projection of the protection structure on the semiconductor layer covers an orthographic projection of the exposed end face of the conductive structure on the semiconductor layer;
etching a part of the semiconductor layer from the side of the second surface of the semiconductor layer along the first direction by using the protection structure as a mask; and
removing the protection structure.

2. The method for preparing the semiconductor structure according to claim 1, wherein the semiconductor layer group further comprises a second dielectric layer, and the second dielectric layer wraps the conductive structure; and when etching the part of the semiconductor layer from the side of the second surface of the semiconductor layer along the first direction by using the protection structure as the mask, the method further comprises:
etching a first part of the second dielectric layer, wherein the first part of the second dielectric layer wraps an outer peripheral side of an end part of the conductive structure away from the electronic element, and is away from the conductive structure in a second direction, and the second direction is parallel to the surface of the semiconductor layer.

3. The method for preparing the semiconductor structure according to claim 2, wherein an edge of the orthographic projection of the protection structure on the semiconductor layer is located between an orthographic projection of a surface of the second dielectric layer away from the conductive structure on the semiconductor layer and an orthographic projection of a surface of the second dielectric layer close to the conductive structure on the semiconductor layer.

4. The method for preparing the semiconductor structure according to any one of claims 1 to 3, wherein forming the protection structure on the side of the conductive structure away from the first dielectric layer comprises:
forming a photoresist layer on a side of the semiconductor layer away from the first dielectric layer; and
patterning the photoresist layer in an exposure development manner, to form the protection structure.

5. The method for preparing the semiconductor structure according to claim 4, wherein before forming the photoresist layer on the side of the semiconductor layer away from the first dielectric layer, the method comprises:
forming an isolation layer on the side of the second surface of the semiconductor layer, wherein the isolation layer covers the semiconductor layer and the exposed end face of the conductive structure; and
before etching the part of the semiconductor layer from the side of the second surface of the semiconductor layer along the first direction by using the protection structure as the mask, the method further comprises:
etching, by using the protection structure as the mask, the part of the semiconductor layer that is covered by the isolation layer.

6. The method for preparing the semiconductor structure according to claim 5, wherein after removing the protection structure, the method further comprises:
forming a third dielectric layer, wherein the third dielectric layer covers the second surface of the semiconductor layer and wraps an end part of the conductive structure protruding from the semiconductor layer; and
removing a part of the third dielectric layer and the isolation layer along the first direction, to expose the end face of the conductive structure away from the electronic element.

7. The method for preparing the semiconductor structure according to any one of claims 1 to 6, wherein there are a plurality of conductive structures, and the plurality of conductive structures comprise a first conductive structure and a second conductive structure; and before removing the part of the semiconductor layer from the side of the second surface of the semiconductor layer along the first direction, to expose the end face of the conductive structure away from the electronic element, a distance between an end face of the first conductive structure away from the electronic element and the second surface of the semiconductor layer is not equal to a distance between an end face of the second conductive structure away from the electronic element and the second surface of the semiconductor layer; and
removing the part of the semiconductor layer from the side of the second surface of the semiconductor layer along the first direction, to expose the end face of the conductive structure away from the electronic element comprises:
removing the part of the semiconductor layer and a part of the conductive structure from the side of the second surface of the semiconductor layer along the first direction, to expose the end faces of the first conductive structure and the second conductive structure away from the electronic element, wherein the exposed end face of the first conductive structure is flush with the exposed end face of the second conductive structure.

8. A semiconductor structure, comprising:
a semiconductor layer group, wherein the semiconductor layer group comprises a first dielectric layer, a semiconductor layer, a second dielectric layer, a conductive structure, and an electronic element; the semiconductor layer comprises a first surface and a second surface that are disposed opposite to each other, the first dielectric layer is disposed adjacent to the first surface of the semiconductor layer, and the electronic element is located in the first dielectric layer; one end of the conductive structure is located in the first dielectric layer and is electrically connected to the electronic element; and the second dielectric layer wraps the conductive structure; and
a third dielectric layer, wherein the third dielectric layer is disposed adjacent to the second surface of the semiconductor layer; and one end of the conductive structure away from the electronic element passes through the semiconductor layer and the third dielectric layer, and an end face of the conductive structure away from the electronic element is exposed in the third dielectric layer, wherein
the second dielectric layer comprises a first subpart and a second subpart, the first subpart is located between the third dielectric layer and the conductive structure, and the second subpart is located between the semiconductor layer and the conductive structure; and a thickness of the first subpart is less than a thickness of the second subpart.

9. A functional chip, comprising at least one semiconductor structure, wherein the semiconductor structure is the semiconductor structure according to claim 8; or
the semiconductor structure is prepared according to the method for preparing the semiconductor structure according to any one of claims 1 to 7.

10. The functional chip according to claim 9, wherein when the functional chip comprises at least two semiconductor structures, the at least two semiconductor structures comprise a first semiconductor structure and a second semiconductor structure; and
an exposed end face of a conductive structure in the first semiconductor structure is bonded to an exposed end face of a conductive structure in the second semiconductor structure.

11. An electronic device, comprising:
a bus; and
the functional chip according to claim 9 or 10, wherein the functional chip is electrically connected to the bus.
